# EUROPÄISCHE PATENTSCHRIFT

(11) **EP 3 152 774 B1**
(45) Veröffentlichungstag und Bekanntmachung des Hinweises auf die Patenterteilung: **19.02.2020**
(21) Anmeldenummer: 15738108.8
(22) Anmeldetag: 16.07.2015
(51) Int. Cl.: H01H 9/56, H02H 3/02, H01H 33/66

(54) **ELEKTRISCHES SCHALTGERÄT MIT PARALLELEN SCHALTSTRECKEN**
ELECTRICAL SWITCHING APPARATUS WITH PARALLEL SWITCH PATHS
APPAREIL DE COMMUTATION ÉLECTRIQUE AVEC DES LANGUETTES DE CONTACT PARALLÈLES

(30) Priorität: 05.08.2014 DE 102014215446
(43) Veröffentlichungstag der Anmeldung: 12.04.2017
(73) Patentinhaber: Siemens Aktiengesellschaft, 80333 München (DE)
(72) Erfinder: FREUNDT, Karsten, 14612 Falkensee (DE); KALETTA, Hartmut, 10435 Berlin (DE); MALITZ, Andreas, 16548 Glienicke (DE); SCHÜMANN, Ulf, 14624 Dallgow-Döberitz (DE); TAYLOR, Erik, D., 13629 Berlin (DE)
(86) Internationale Anmeldenummer: PCT/EP2015/066282
(87) Internationale Veröffentlichungsnummer: WO 2016/020166

(56) Entgegenhaltungen:
- EP-A1- 1 536 442
- WO-A1-90/03656
- DE-A1- 3 833 166
- DE-A1- 19 525 286
- DE-C1- 19 809 828

## Beschreibung

Die Erfindung betrifft ein Verfahren zum Betrieb eines Generatorschalters. Darüber hinaus betrifft die Erfindung einen solchen Generatorschalter.

Elektrische Schaltgeräte, bei denen einer Phase mindestens zwei parallele Schaltstrecken zugeordnet sind, sind aus dem Stand der Technik bekannt. Bei elektrischen Schaltgeräten erfordert das Führen hoher Nennströme niederohmige Schaltstrecken, um den Temperaturanforderungen zu genügen, insbesondere die Erwärmung von Schaltgerätekomponenten zu begrenzen. Die Verwendung paralleler Schaltstrecken kann dabei den elektrischen Gesamtwiderstand der Schaltstreckenanordnung verringern.

Wird jedoch eine der parallelen Schaltstrecke kurz vor einem Stromnulldurchgang geöffnet, insbesondere einen Nulldurchgang vor einer großen Halbwelle, kommt es aufgrund eines Löschversuches zu einem weiteren Stromfluss in dieser Schaltstrecke. Besitzt diese Schaltstrecke dann nicht das notwendige Löschvermögen, um den Strom im folgenden Stromnulldurchgang abzuschalten, kommt es zum Löschversagen. Jede einzelne der parallelen Schaltstrecke muss daher ein ausreichend hohes Löschvermögen besitzen, um eine solche Situation zu beherrschen.

Die EP1536442A1 offenbart parallele Schaltstrecken für die einzelnen Phasen eines dreiphasiges Schaltgerät.

Aus der WO90/03656A1 ist ein Öffnen von Schaltkontakten von unterschiedlichen Phasen in Relation zum Nulldurchgang der Phasen und der zum Öffnen Phasen untereinander bekannt.

In der DE19809828C1 ist ein synchronisiertes Öffnen und Schließen von Niederspannungsschaltern offenbart.

Die DE19525286A1 offenbart ein zeitversetztes Schalten von benachbarten Polen (unterschiedlicher Phasen) um den Polmittelabstand verringern zu können.

Eine Aufgabe der vorliegenden Erfindung ist es, einen zuverlässigen Betrieb eines elektrischen Schaltgerätes mit parallelen Schaltstrecken zu gewährleisten, die ein im Vergleich zu herkömmlichen parallelen Schaltstrecken geringeres Schaltleistungsvermögen aufweisen.

Diese Aufgabe wird durch ein Verfahren nach Anspruch 1 bzw. ein Schaltgerät nach Anspruch 7 gelöst. Vorteilhafte Ausführungen der Erfindung sind in den Unteransprüchen angegeben.

Die im Folgenden im Zusammenhang mit dem Verfahren erläuterten Vorteile und Ausgestaltungen gelten sinngemäß auch für das erfindungsgemäße Schaltgerät und umgekehrt.

Die Begriffe Schaltleistungsvermögen, Schaltleistung und Schaltvermögen werden nachfolgend synonym gebraucht.

Das erfindungsgemäße Verfahren dient zum Betrieb eines elektrischen Schaltgerätes, einen Generatorschalter, bei welchem Schaltgerät einer Phase mindestens zwei parallele Schaltstrecken zugeordnet sind, und umfasst die folgenden Schritte: Erfassen von Stromnulldurchgängen in dieser Phase, Ansteuern wenigstens eines in Wirkverbindung mit den Schaltstrecken stehenden Schaltmechanismus derart, dass alle dieser Phase zugeordneten parallelen Schaltstrecken innerhalb eines Zeitfensters öffnen, das in Beziehung zu den Stromnulldurchgängen in dieser Phase steht.

Das erfindungsgemäße elektrische Schaltgerät, ein Generatorschalter, umfasst mindestens zwei einer Phase zugeordnete, parallele Schaltstrecken, Mittel zum Erfassen von Stromnulldurchgängen in dieser Phase und Mittel zum Ansteuern wenigstens eines in Wirkverbindung mit den Schaltstrecken stehenden Schaltmechanismus derart, dass alle dieser Phase zugeordneten parallelen Schaltstrecken innerhalb eines Zeitfensters öffnen, das in Beziehung zu den Stromnulldurchgängen in dieser Phase steht.

Eine Kernidee der Erfindung ist es, einer Phase zugeordnete Schaltstrecken eines Schaltgerätes im Parallelbetrieb so einzusetzen, dass sie innerhalb eines definierten Öffnungsfensters öffnen, wobei dieses Öffnungsfenster in Beziehung zu den Stromnulldurchgängen in dieser Phase steht. Unter einem Öffnungsfenster wird dabei ein Zeitfenster verstanden, in dem die Schaltstücke einer Schaltstrecke tatsächlich öffnen.

Durch die definierte Zuordnung des Öffnungsfensters zu den Stromnulldurchgängen kann auf einfache Art und Weise erreicht werden, dass jede einzelne dieser parallelen Schaltstrecken lediglich ein Schaltvermögen aufweisen muss, welches geringer ist, als dasjenige Schaltvermögen, das diese Schaltstrecke aufweisen müsste, wenn sie den zu schaltenden Strom alleine löschen müsste.

Erfindungsgemäß sind einer Phase mehrere parallele Schaltstrecken zugeordnet. Im Gegensatz zu einem ungesteuerten Öffnen, wie im Stand der Technik, wird ein synchronisiertes Öffnen der parallelen Schaltstrecken innerhalb eines definierten Öffnungsfensters vorgeschlagen. Mit anderen Worten liegen die Trennungszeitpunkte der Schaltstücke aller parallelen Schaltstrecken einer Phase innerhalb eines definierten Öffnungsfensters. Durch eine geeignete Wahl dieses Öffnungsfensters wird sichergestellt, dass alle parallelen Schaltstrecken nach einem Stromnulldurchgang und zeitlich ausreichend beabstandet vor dem nächsten Stromnulldurchgang öffnen. Daher "teilen" sich die Schaltstrecken den zu schaltenden Strom und gehen gemeinsam durch den nächsten Stromnulldurchgang. Dadurch wird gewährleistet, dass nicht nur eine einzige Schaltstrecke den gesamten Strom tragen muss. Je nachdem, wie viele parallele Schaltstrecken in einer Phase vorgesehen sind, muss stattdessen jede einzelne dieser Schaltstrecken nur noch einen Bruchteil des Stromes beherrschen. Die Gesamtbelastung jeder einzelnen der parallelen Schaltstrecken des Schaltgerätes, insbesondere die Belastung der Schaltstücke, ist deutlich geringer als im Stand der Technik. Mit der vorliegenden Erfindung wird daher ein zuverlässiger Betrieb eines elektrischen Schaltgerätes mit parallelen Schaltstrecken gewährleistet, die ein im Vergleich zu herkömmlichen parallelen Schaltstrecken geringeres Schaltleistungsvermögen aufweisen.

Da die verwendeten Schaltstrecken eine reduzierte Schaltleistung aufweisen, verringern sich die Herstellungskosten eines zum Schalten eines bestimmten Stromes ausgelegten Schaltgerätes mit solchen parallelen Schaltstrecken gegenüber den Herstellungskosten eines nach dem Stand der Technik gefertigten Schaltgerätes zum Schalten gleicher Ströme. Alternativ kann ein Schaltgerät, das parallele Schaltstrecken mit unverändertem Schaltvermögen verwendet, durch den Einsatz des erfindungsgemäßen Verfahrens zur Erzeugung höherer Gesamtabschaltleistungen genutzt werden.

Handelt es sich um ein Schaltgerät für ein mehrphasiges Netz, dann sind wenigstens einer der Phasen die mindestens zwei parallelen Schaltstrecken zugeordnet, die auf erfindungsgemäße Art und Weise angesteuert werden. Vorzugsweise weisen jedoch alle Phasen des mehrphasigen Netzes die mindestens zwei parallelen Schaltstrecken auf, welche dann erfindungsgemäß angesteuert werden.

Die Erfindung ist nicht auf eine bestimmte Art von elektrischen Schaltgeräten beschränkt. Besonders vorteilhaft anwendbar ist die Erfindung jedoch bei Schaltgeräten, die für hohe Ströme geeignet sind, insbesondere für Generatorschalter, wie beispielsweise einen Vakuum-Generatorschalter für Betriebsströme bis 6300 A und Kurzschluss-Ausschaltströme bis 72 kA.

Die oben beschriebenen Eigenschaften, Merkmale und Vorteile dieser Erfindung sowie die Art und Weise, wie diese erreicht werden, werden klarer und deutlicher verständlich im Zusammenhang mit der folgenden Beschreibung der Ausführungsbeispiele, die im Zusammenhang mit den Zeichnungen näher erläutert werden. Dabei zeigen:
- FIG 1: ein stark vereinfachtes Schaltbild eines erfindungsgemäßen Schaltgerätes in einem dreiphasigem Netz,
- FIG 2: ein Detail des Schaltgerätes mit mehreren parallelen Unterbrechereinheiten, die einer Phase des Netzes zugeordnet sind,
- FIG 3: den Strom I einer Phase, aufgetragen gegen die Zeit t, für einen Ausschaltvorgang.

Sämtliche Figuren zeigen die Erfindung lediglich schematisch und mit ihren wesentlichen Bestandteilen. Gleiche Bezugszeichen entsprechen dabei Elementen gleicher oder vergleichbarer Funktion.

Dargestellt ist ein dreiphasiges elektrisches Schaltgerät 1 für Mittel- oder Hochspannung, beispielsweise ein Generatorschalter. Betrachtet wird beispielhaft ein Kurzschlussfall. Das Schaltgerät 1 ist zum Schalten bzw. Unterbrechen zeitlich phasenverschobener Ströme ausgelegt. Hierzu verfügt es über schaltbare Kontaktsysteme 2 für jede der drei Phasen 18, 19, 20 (R, S, T) einer Energieübertragungsleitung. Wenigstens einer dieser Phasen 18, 19, 20, vorzugsweise aber allen Phasen 18, 19, 20, sind dabei drei parallele Unterbrechereinheiten zugeordnet. Bei den Unterbrechereinheiten handelt es sich beispielsweise um Vakuumröhren. Diese besitzen die Eigenschaft, dass deren Schaltstrecken 4, 5, 6 beim Ausschalten ihre dielektrische Festigkeit sehr rasch wiedererlangen.

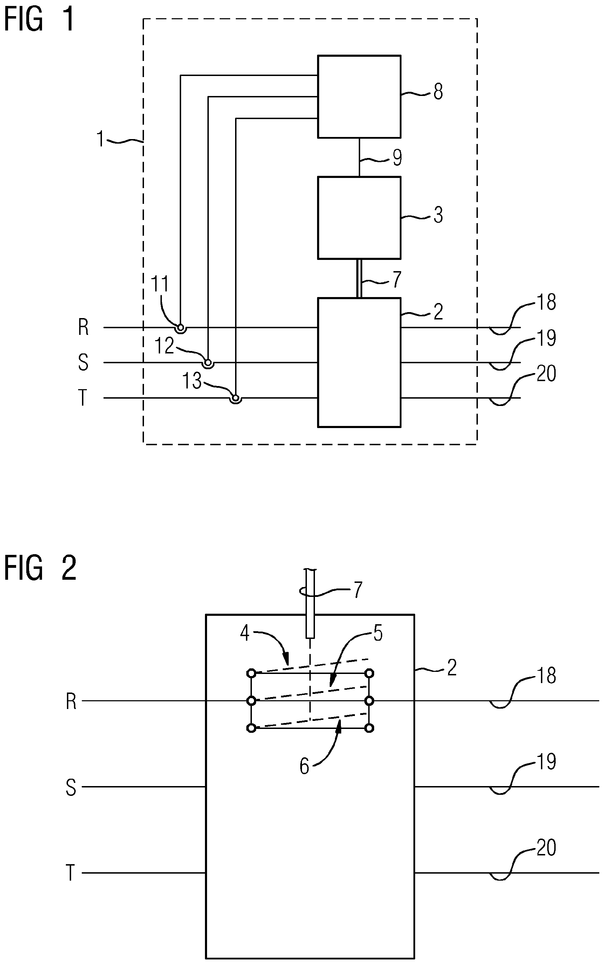

Eine Antriebsvorrichtung 3 des Schaltgerätes 1 ist zum gleichzeitigen Antrieb aller einer Phase 18, 19, 20 zugeordneten Kontaktsysteme 2 ausgebildet. Anders ausgedrückt dient eine einzige Antriebsvorrichtung 3 zum gleichzeitigen Öffnen aller parallelen Schaltstrecken 4, 5, 6 einer Phase 18, 19, 20. Zu diesem Zweck steht der wenigstens eine Schaltmechanismus der Antriebsvorrichtung 3 mit diesen Schaltstrecken 4, 5, 6, genauer gesagt mit den Schaltstücken dieser Schaltstrecken 4, 5, 6, über eine gemeinsame Antriebswelle 7 in Wirkverbindung, siehe FIG 2.

Der Schaltmechanismus der Antriebsvorrichtung 3 wird von einem elektrischen Auslösesteuergerät 8 angesteuert, das mit der Antriebsvorrichtung 3 über eine Steuerleitung 9 verbunden ist. Anders ausgedrückt umfasst das Schaltgerät 1 eine Steuereinrichtung in Gestalt eines Auslösesteuergerätes 8 zum Erzeugen eines Auslösesignals für die Antriebsvorrichtung 3 nach dem Auftreten eines Kurzschlusses. Nach einem solchen Auslösesignal wird zum Öffnen der parallelen Schaltstrecken 4, 5, 6 ein Ausschaltbefehl an die Antriebsvorrichtung 3 ausgegeben. Hierdurch wird eine Öffnungsbewegung der Schaltstücke einer der parallelen Schaltstrecken 4, 5, 6 ausgelöst. Eine Verzögerung zwischen dem Ausschaltbefehl und dem tatsächlichen Öffnen der Schaltstücke ergibt sich durch die Schaltereigenzeit, die aus den mechanischen Eigenschaften des Schaltgerätes 1 und der Kontaktsysteme 2 sowie den Übertragungszeiten zur Übertragung der Befehle von dem Auslösesteuergerät 8 zu der Antriebsvorrichtung 3 resultiert.

Dem Auslösesteuergerät 8 wird über mindestens einen der jeweiligen Phase 18, 19, 20 zugeordneten Stromwandler 11, 12, 13 eine elektrische Größe zugeführt, die dem in der Phase 18, 19, 20 fließenden Strom I proportional ist und mit der die Stromnulldurchgänge 31, 32 in dieser Phase 18, 19, 20 erfasst werden. Mit anderen Worten erfasst und verarbeitet das Auslösesteuergerät 8 die Messwerte der Stromwandler 11, 12, 13 und damit auch die Stromnulldurchgänge 31, 32 des Kurzschlussstromes in der jeweiligen Phase 18, 19, 20. Anstelle des Stromes I oder zusätzlich zu diesen Stromgrößen kann auch die elektrische Spannung der Phasen 18, 19, 20 mit Hilfe geeigneter Meßaufnehmer erfasst und als Eingangsgröße für das Auslösesteuergerät 8 verwendet werden.

Bei der Verwendung mehrerer paralleler Schaltstrecken 4, 5, 6 für eine Phase 18, 19, 20 kann es, selbst dann, wenn ein gleichzeitiges Öffnung dieser Schaltstrecken 4, 5, 6 beabsichtigt ist, vorkommen, dass eine der Schaltstrecken 4, 5, 6 vor einem Stromnulldurchgang 31, 32 und eine andere der Schaltstrecken 4, 5, 6 nach einem Stromnulldurchgang 31, 32 öffnet. Ein genau gleichzeitiges Öffnen, entweder vor oder nach einem Stromnulldurchgang 31, 32, ist nahezu ausgeschlossen. Diejenige Schaltstrecke 4, 5, 6, in der im Anschluss an einen Öffnungsvorgang der Strom noch fließt, muss somit in der Lage sein, den Strom bei dem nächsten Stromnulldurchgang 31, 32 zu löschen. Die im Stand der Technik verwendeten Schaltstrecken müssen daher vergleichsweise groß dimensioniert sein.

Vor diesem Hintergrund schlägt die Erfindung vor, dass das Öffnen der parallelen Schaltstrecken 4, 5, 6 in jedem Fall zwischen zwei Stromnulldurchgängen 31, 32 erfolgt. Insbesondere soll sichergestellt sein, dass alle parallelen Schaltstrecken 4, 5, 6 einer Phase 18, 19, 20 vor dem nächsten Stromnulldurchgang 31, 32 geöffnet sind. Zu diesem Zweck erfolgt ein gezieltes Ansteuern der parallelen Schaltstrecken 4, 5, 6 nach einem Stromnulldurchgang 31, 32. Es wird dabei gezielt in Kauf genommen, dass durch die Gesamtanordnung der parallelen Schaltstrecken 4, 5, 6 einer Phase 18, 19, 20 eine ganze Halbwelle durchfließt. Dieser Strom wird jedoch aufgrund der Parallelität der Schaltstrecken 4, 5, 6 auf die Mehrzahl der vorhandenen parallelen Schaltstrecken 4, 5, 6 aufgeteilt, so dass die Gesamtbelastung für jede einzelne dieser parallelen Schaltstrecken 4, 5, 6 wesentlich geringer und damit deutlich besser beherrschbar ist, als wenn eine einzelne Schaltstrecke 4, 5, 6 die nächste Halbwelle ganz alleine tragen müsste. Bei der Verwendung von Vakuumröhren reduziert sich insbesondere die Belastung der Schaltstücke innerhalb der Vakuumschaltkammern.

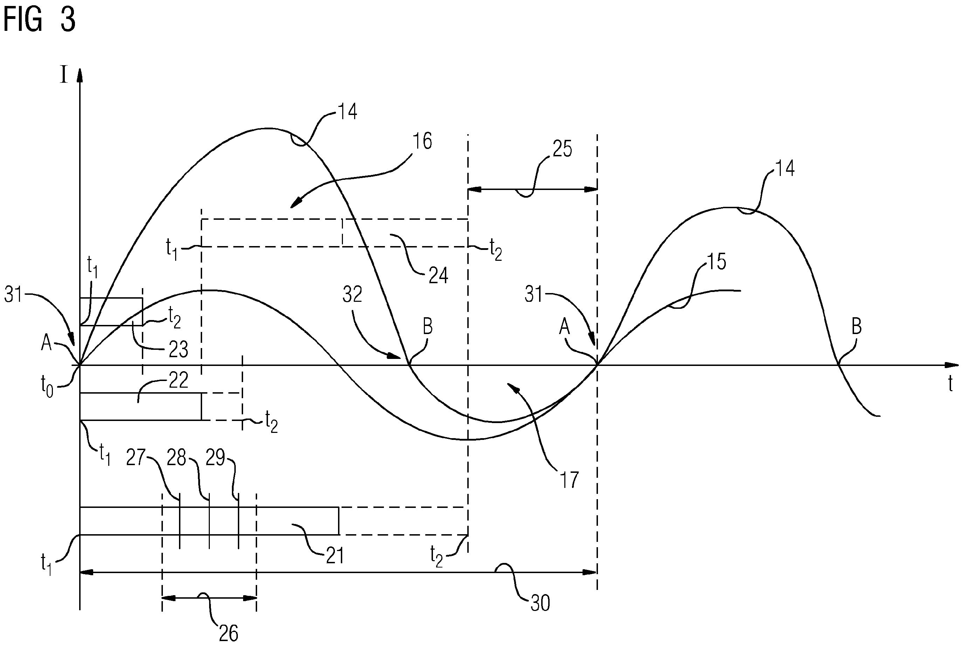

Dabei ist zu beachten, dass es sich bei Schaltvorgängen oder Kurzschlüssen um einen asymmetrischen Strom 14 handelt, der aufgrund der im System vorhandenen Induktivitäten einen Gleichstromanteil enthält und erst nach und nach abklingt. Nach einem Abklingen des Gleichstromgliedes im Kurschlussstrom ergibt sich der in FIG 3 dargestellte symmetrische Stromverlauf 15. Bei einem asymmetrischen Strom 14 wechseln sich jeweils eine große Halbwelle 16 und kleine Halbwelle 17 ab. Zur besseren Veranschaulichung wurden in FIG 3 Stromnulldurchgänge, nach denen eine große Halbwelle 16 folgt, mit "A" und Stromnulldurchgänge, nach denen eine kleine Halbwelle 17 folgt, mit "B" bezeichnet.

Die Erfindung schlägt weiter vor, dass diejenige parallele Schaltstrecke 4, 5, 6, die zuerst öffnet, möglichst kurz nach einem Stromnulldurchgang 31 vom Typ "A" öffnet. Unmittelbar anschließend öffnen die übrigen Schaltstrecken 4, 5, 6 mit ihren Gleichlauffehlern. Im Ergebnis wird sichergestellt, dass alle parallelen Schaltstrecken 4, 5, 6 nach einem Stromnulldurchgang 31 vom Typ "A" geöffnet sind.

Die Erfindung schlägt weiter vor, dass das Öffnungsfenster vor dem nächsten Stromnulldurchgang 31, 32 endet, insbesondere vor dem nächsten Stromnulldurchgang 32 vom Typ "B". Genauer gesagt soll das Öffnungsfenster zeitlich so weit entfernt von dem nächsten Stromnulldurchgang 31, 32 enden, dass sichergestellt ist, dass der dielektrische Hub der Schaltstrecken 4, 5, 6 für die benötigte Löschleistung ausreicht. Mit anderen Worten gehen alle parallelen Schaltstrecken 4, 5, 6 gemeinsam durch den nächsten Stromnulldurchgang 31, 32, der zeitlich soweit entfernt ist, dass die Schaltstrecken 4, 5, 6 den zum Löschen des Stromes benötigen dielektrischen Hub aufweisen. Die Schaltstrecken 4, 5, 6 löschen den Strom dann sicher.

Selbst wenn, beispielsweise aufgrund einer entsprechenden Lage des Öffnungsfensters und/oder eines erhöhten Gleichlauffehlers der nachfolgend öffnenden Schaltstrecken 4, 5, 6, nicht alle parallelen Schaltstrecken 4, 5, 6 bei einem Stromnulldurchgang 32 vom Typ "B" geöffnet sind, so muss von diesen Schaltstrecken 4, 5, 6 maximal der symmetrische Strom getragen werden. Kann hingegen aufgrund einer geeigneten Wahl des Öffnungsfensters sichergestellt werden, dass alle parallelen Schaltstrecken 4, 5, 6 gleichzeitig bei einem Stromnulldurchgang 32 vom Typ "B" löschen, dann können diese Schaltstrecken 4, 5, 6 sogar so ausgelegt werden, dass sie weniger Strom beherrschen müssen, als für den symmetrischen Abschaltfall.

Erfindungsgemäß steht das Öffnungsfenster somit in fester Beziehung zu den Stromnulldurchgängen in dieser Phase. Einer der Vorteile der Erfindung ist es daher, dass die Gesamtbelastung der parallelen Schaltstrecken 4, 5, 6 aufgrund der Aufteilung des Stromes so gering ist, dass die Schaltstrecken 4, 5, 6 diesen Strom problemlos löschen und der Spannung widerstehen können. Anders ausgedrückt kann mit der Erfindung erreicht werden, dass die erstlöschende Schaltstrecke 4, 5, 6 die notwendige elektrische Festigkeit erreicht und eine Wiederzündung vermieden wird.

Sind beispielsweise drei parallele Schaltstrecken 4, 5, 6 in einer Phase 18 vorgesehen, wie in FIG 2 abgebildet, dann werden diese derart angesteuert, dass sie innerhalb eines definierten Öffnungsfensters nach einem Stromnulldurchgang 31 vom Typ "A"

alle stromdurchflossen sind, wobei jede der Schaltstrecken 4, 5, 6 lediglich noch ein Drittel einer großen Halbwelle 16 tragen muss. Alle parallelen Schaltstrecken 4, 5, 6 einer Phase 18 gehen gemeinsam durch den nächstfolgenden Stromnulldurchgang 32 vom Typ "B" und löschen den Strom. Mit anderen Worten wird bei der Erfindung das Löschen des Stromes in einer Phase 18 auf mehrere parallele Schaltstrecken 4, 5, 6 aufgeteilt. Soll beispielsweise ein Strom von 150 kA abgeschaltet werden und sind in einer Phase drei parallele Schaltstrecken 4, 5, 6 vorgesehen, dann muss jede dieser parallelen Schaltstrecken 4, 5, 6 lediglich 50 kA beherrschen. Allgemeiner formuliert fließt in n parallelen Schaltstrecken 4, 5, 6 nur der n-te Teil des Stromes.

Kann mit anderen Worten gewährleistet werden, dass bei einem Stromnulldurchgang vom Typ "B" der Strom sicher gelöscht wird, so kann hieraus abgeleitet werden, wie hoch das Löschvermögen der einzelnen parallelen Schaltstrecken 4, 5, 6 dimensioniert werden muss. Werden beispielsweise drei oder fünf parallele Schaltstrecken 4, 5, 6 in dem definierten Öffnungsfenster geöffnet, dann braucht im einfachsten Fall jede dieser Schaltstrecken 4, 5, 6 nur ein Drittel bzw. ein Fünftel einer großen Halbwelle 16 beherrschen.

Nachfolgend werden mögliche Öffnungsfenster genauer beschrieben. In diesem Zusammenhang wird darauf hingewiesen, dass diese Zeitfenster denjenigen Bereich beschreiben, in dem die parallelen Schaltstrecken 4, 5, 6 tatsächlich öffnen, es also zu einer synchronisierten Öffnung der Schaltstücke kommt. Das Ansteuern des wenigstens einen Schaltmechanismus der Antriebsvorrichtung 3 erfolgt entsprechend der Eigenzeit des Schaltgerätes 1 zu einem entsprechend früheren Zeitpunkt.

Beginn und Ende des Öffnungsfensters werden von den Zeitpunkten t₁ und t₂ bestimmt. Bei einer Netzfrequenz von 50 Hertz (Periode T = 20 ms) haben sich die nachfolgend erläuterten Zeitpunkte als besonders vorteilhaft erwiesen, jeweils gerechnet ab dem Zeitpunkt (t₀) eines Stromnulldurchganges vom Typ "A".

Wesentlich ist, dass das Öffnungsfenster nach einem Stromnulldurchgang in der entsprechenden Phase 18 beginnt, insbesondere nach einem Stromnulldurchgang 31 vom Typ "A". Vorzugsweise schließt sich das Öffnungsfenster dabei unmittelbar an diesen Stromnulldurchgang 31 an. In diesen Fällen liegt somit der Beginn des Öffnungsfensters 21, 22, 23 unmittelbar nach einem Stromnulldurchgang 31 vom Typ "A" (t₁ = 0 ms). Das Ende des Öffnungsfensters 21, 22, 23 liegt vorzugsweise wenige Millisekunden nach diesem Stromnulldurchgang 31. In einer vorteilhaften Ausführungsform der Erfindung beträgt t₂ = 10 ms bis 15 ms. Das Öffnungsfenster 21 ist insgesamt somit 10 bis 15 ms lang. Noch vorteilhafter ist eine Ausführungsform, bei der t₂ = 5 bis 6 ms beträgt, das Öffnungsfenster 22 insgesamt also nur 5 bis 6 Millisekunden lang ist. Noch vorteilhafter ist eine Ausführungsform, bei der t₂ = 3 ms beträgt, das Öffnungsfenster 23 insgesamt also nur 3 Millisekunden lang ist. Anders ausgedrückt liegt t₁ in diesen Fällen 20 ms vor dem nächstfolgenden Stromnulldurchgang 31 vom Typ "A" und t₂ liegt, je nach Ausführungsform, nur 5 bis 10 ms bzw. 14 bis 15 ms bzw. sogar 17 ms vor dem nächsten Stromnulldurchgang 31 vom Typ "A". Besonders vorteilhaft sind hier diejenigen Öffnungsfenster 22, 23, die so kurz sind, dass sie vor dem nächsten Stromnulldurchgang 31 gleicher Polarität enden, hier also vor dem nächsten Stromnulldurchgang 31 vom Typ "A".

Alternativ beginnt das Öffnungsfenster erst 5 bis 10 Millisekunden nach einem Stromnulldurchgang 31 vom Typ "A" (t₁ = 5 ms bis 10 ms) und endet vergleichsweise spät (t₂ = 10 ms bis 15 ms) . Das Öffnungsfenster 24 ist dann zwischen 5 ms und 15 ms lang. In diesem Fall liegt t₁ somit 10 bis 15 Millisekunden vor dem nächsten Stromnulldurchgang 31 vom Typ "A" und t₂ liegt 5 bis 10 Millisekunden vor dem nächsten Stromnulldurchgang 31 vom Typ "A".

Bei solchen Ausführungsformen, bei denen das Öffnungsfenster 21 größer gewählt ist (z. B. 10 ms bis 15 ms), und bei solchen Ausführungsformen, bei denen das Öffnungsfenster 24 verschoben ist, also nicht unmittelbar nach einem Stromnulldurchgang von Typ "A", sondern beispielsweise 5 bis 10 Millisekunden später

beginnt, wird in Kauf genommen, dass eine der parallelen Schaltstrecken 4, 5, 6 einen Löschversuch bei einem möglichen Öffnen kurz vor einem Stromnulldurchgang 32 vom Typ "B" durchführt. Da jedoch zum Abschalten dieser kleinen Halbwelle 17 ein geringeres Schaltleistungsvermögen benötigt wird, kann diese verbleibende parallele Schaltstrecke 4, 5, 6 diese Situation alleine beherrschen. Erfolgt sogar ein Öffnen mehrerer paralleler Schaltstrecken 4, 5, 6 nach einem Stromnulldurchgang 32 vom Typ "B", so wird der Strom wiederum geteilt und der dielektrische Hub ist sicher ausreichend, den Strom beim nächsten Stromnulldurchgang 31 vom Typ "A" abzuschalten.

In allen Fällen, auch in den zuletzt genannten, wird sichergestellt, dass das Öffnungsfenster 21, 22, 23, 24 zeitlich soweit von dem nächsten Stromnulldurchgang 31 vom Typ "A" beabstandet ist, dass keine kritische Situation entsteht. Der zeitliche Mindestabstand 25 beträgt vorzugsweise mindestens ein Viertel der Dauer einer Periode T der Netzfrequenz, bei einer Netzfrequenz von 50 Hz also 5 ms.

Eine optimale Aufteilung des Stromes auf die Anzahl der parallelen Schaltstrecken 4, 5, 6 und damit eine Berechenbarkeit der Dimensionierung und des benötigten Löschvermögens der einzelnen Schaltstrecken 4, 5, 6 ist dann besonders gut möglich, wenn der Gleichlauffehler der parallelen Schaltstrecken 4, 5, 6 möglichst gering ist, diese also möglichst kurz nacheinander öffnen. Von der erstöffnenden Schaltstrecke 4, 5, 6 bis zur letztöffnenden Schaltstrecke 4, 5, 6 liegt gemäß der Erfindung ein zeitlicher Abstand 26, der höchstens einem Fünftel der Dauer einer Periode T der Netzfrequenz entspricht, also beispielsweise 4 ms bei einer Netzfrequenz von 50 Hz. Beispielhaft sind in FIG 3 in dem Öffnungsfenster 21 die Öffnungszeitpunkte 27, 28, 29 der Schaltstrecken 4, 5, 6 eingetragen.

Obwohl die Erfindung im Detail durch das bevorzugte Ausführungsbeispiel näher illustriert und beschrieben wurde, so ist die Erfindung nicht auf die offenbarten Beispiele eingeschränkt und andere Variationen können vom Fachmann hieraus abgeleitet werden, ohne den Schutzumfang der angefügten Ansprüche zu verlassen.

## Patentansprüche

1. Verfahren zum Betrieb eines Generatorschalters (1) für Mittel- oder Hochspannung, bei welchem Schaltgerät (1) einer Phase (18, 19, 20) mindestens zwei parallele Schaltstrecken (4, 5, 6) zugeordnet sind, mit den Schritten:
- Erfassen von Stromnulldurchgängen (31, 32) in dieser Phase (18, 19, 20),
- Ansteuern wenigstens eines in Wirkverbindung mit den Schaltstrecken (4, 5, 6) stehenden Schaltmechanismus (3) derart, dass alle dieser Phase (18, 19, 20) zugeordneten parallelen Schaltstrecken (4, 5, 6) innerhalb eines Zeitfensters (21, 22, 23, 24) öffnen, das in Beziehung zu den Stromnulldurchgängen (31, 32) in dieser Phase (18, 19, 20) steht,
**dadurch gekennzeichnet, dass**
ein zeitlicher Abstand (26) zwischen dem Öffnen einer erstöffnenden parallelen Schaltstrecke (4, 5, 6) und dem Öffnen einer letztöffnenden parallelen Schaltstrecke (4, 5, 6) höchstens einem Fünftel einer Dauer einer Periode (30) einer Netzfrequenz entspricht.

2. Verfahren nach Anspruch 1, wobei das Zeitfenster (21, 22, 23, 24) nach einem Stromnulldurchgang (31, 32) in dieser Phase (18, 19, 20) beginnt und vor dem nächsten Stromnulldurchgang (31, 32) endet.

3. Verfahren nach Anspruch 1 oder 2, wobei das Zeitfenster (21, 22, 23, 24) nach einem Stromnulldurchgang (31) in dieser Phase (18, 19, 20) beginnt und vor dem nächsten Stromnulldurchgang (31) gleicher Polarität endet.

4. Verfahren nach einem der Ansprüche 1 bis 3, wobei das Zeitfenster (21, 22, 23, 24) nach einem Stromnulldurchgang (31) einer großen Halbwelle (16) in dieser Phase (18, 19, 20) beginnt und vor dem nächsten Stromnulldurchgang (31) dieser großen Halbwelle (16) endet.

5. Verfahren nach einem der Ansprüche 1 bis 4, wobei sich das Zeitfenster (21, 22, 23, 24) unmittelbar an einen Stromnulldurchgang (31, 32) in dieser Phase (18, 19, 20) anschließt.

6. Verfahren nach einem der Ansprüche 1 bis 5, wobei der zeitliche Mindestabstand (25) des Zeitfensters (21, 22, 23, 24) zu dem nächsten Stromnulldurchgang (31, 32) mindestens einem Viertel der Dauer einer Periode (30) der Netzfrequenz entspricht.

7. Generatorschalter (1) für Mittel- oder Hochspannung,
- mit mindestens zwei einer Phase (18, 19, 20) zugeordneten, parallelen Schaltstrecken (4, 5, 6),
- mit Mitteln (8, 11, 12, 13) zum Erfassen von Stromnulldurchgängen (31, 32) in dieser Phase (18, 19, 20) und
- mit Mitteln (3, 8) zum Ansteuern wenigstens eines in Wirkverbindung mit den Schaltstrecken (4, 5, 6) stehenden Schaltmechanismus (3) derart, dass alle dieser Phase (18, 19, 20) zugeordneten parallelen Schaltstrecken (4, 5, 6) innerhalb eines Zeitfensters (21, 22, 23, 24) öffnen, das in Beziehung zu den Stromnulldurchgängen (31, 32) in dieser Phase (18, 19, 20) steht,
**dadurch gekennzeichnet, dass**
ein zeitlicher Abstand (26) zwischen dem Öffnen einer erstöffnenden parallelen Schaltstrecke (4, 5, 6) und dem Öffnen einer letztöffnenden parallelen Schaltstrecke (4, 5, 6) höchstens einem Fünftel einer Dauer einer Periode (30) der Netzfrequenz entspricht.

8. Generatorschalter (1) nach Anspruch 7, der für ein mehrphasiges Netz ausgebildet ist.

## Claims

1. Method for the operation of a generator switch (1) for medium or high voltage, in which switching device (1) at least two parallel switching paths (4, 5, 6) are allocated to a phase (18, 19, 20), with the steps:
- detection of current zero crossings (31, 32) in this phase (18, 19, 20),
- actuation of at least one switching mechanism (3), which is operatively connected to the switching paths (4, 5, 6), in such a way that all parallel switching paths (4, 5, 6) allocated to this phase (18, 19, 20) open within a window of time (21, 22, 23, 24) that is correlated to the current zero crossings (31, 32) in this phase (18, 19, 20),
**characterized in that**
a time separation (26) between the opening of a first of the parallel switching paths (4, 5, 6) to open and the opening of a last of the parallel switching paths (4, 5, 6) to open corresponds to at most one fifth of a duration of a period (30) of a network frequency.

2. Method according to Claim 1, wherein the window of time (21, 22, 23, 24) starts after a current zero crossing (31, 32) in this phase (18, 19, 20) and ends before the next current zero crossing (31, 32).

3. Method according to Claim 1 or 2, wherein the window of time (21, 22, 23, 24) starts after a current zero crossing (31) in this phase (18, 19, 20) and ends before the next current zero crossing (31) of the same polarity.

4. Method according to one of Claims 1 to 3, wherein the window of time (21, 22, 23, 24) starts after a current zero crossing (31) of a large half wave (16) in this phase (18, 19, 20) and ends before the next current zero crossing (31) of this large half wave (16).

5. Method according to one of Claims 1 to 4, wherein the window of time (21, 22, 23, 24) follows a current zero crossing (31, 32) in this phase (18, 19, 20) immediately.

6. Method according to one of Claims 1 to 5, wherein the minimum time separation (25) of the window of time (21, 22, 23, 24) and the next current zero crossing (31, 32) corresponds to at least one quarter of the duration of a period (30) of the network frequency.

7. Generator switch (1) for medium or high voltage,
- with at least two parallel switching paths (4, 5, 6) allocated to a phase (18, 19, 20),
- with means (8, 11, 12, 13) for detecting current zero crossings (31, 32) in this phase (18, 19, 20) and
- with means (3, 8) for actuating at least one switching mechanism (3), which is operatively connected to the switching paths (4, 5, 6), in such a way that all parallel switching paths (4, 5, 6) allocated to this phase (18, 19, 20) open within a window of time (21, 22, 23, 24) that is correlated to the current zero crossings (31, 32) in this phase (18, 19, 20),
**characterized in that**
a time separation (26) between the opening of a first of the parallel switching paths (4, 5, 6) to open and the opening of a last of the parallel switching paths (4, 5, 6) to open corresponds to at most one fifth of a duration of a period (30) of the network frequency.

8. Generator switch (1) according to Claim 7 that is designed for a multi-phase network.

## Revendications

1. Procédé pour faire fonctionner un interrupteur (1) de générateur de la moyenne ou de la haute tension, appareil (1) de coupure dans lequel, à une phase (18, 19, 20) sont associées au moins deux sections (4, 5, 6) de coupure parallèles, comprenant les stades :
- détection de passages (31, 32) par zéro du courant dans cette phase (18, 19, 20),
- commande d'au moins un mécanisme (3) de coupure en liaison d'action avec les sections (4, 5, 6) de coupure, de manière à ouvrir toutes les sections (4, 5, 6) de coupure parallèles associées à cette phase (18, 19, 20), dans un créneau (21, 22, 23, 24) temporel, qui est en relation avec les passages (31, 32) par zéro du courant dans cette phase (8, 19, 20),
**caractérisé en ce qu'**
une distance (26) dans le temps, entre l'ouverture d'une première section (4, 5, 6) de coupure parallèle s'ouvrant en premier et l'ouverture d'une section (4, 5, 6) de coupure parallèle s'ouvrant en dernier, correspond, au plus, à un cinquième d'une durée d'une période (30) d'une fréquence du secteur.

2. Procédé suivant la revendication 1, dans lequel le créneau (21, 22, 23, 24) temporel commence après un passage (31, 32) par zéro du courant dans cette phase (18, 19, 20) et se termine avant le prochain passage (31, 32) par zéro du courant.

3. Procédé suivant la revendication 1 ou 2, dans lequel le créneau (21, 22, 23, 24) temporel commence après un passage (31) par zéro du courant dans cette phase (18, 19, 20) et se termine avant le prochain passage (31) par zéro du courant de même polarité.

4. Procédé suivant l'une des revendications 1 à 3, dans lequel le créneau (21, 22, 23, 24) temporel commence après un passage (31) par zéro du courant d'une grande demi-onde (16) dans cette phase (18, 19, 20) et se termine avant le prochain passage (3) par zéro du courant de cette grande demi-onde (16).

5. Procédé suivant l'une des revendications 1 à 4, dans lequel le créneau (21, 22, 23, 24) temporel suit directement un passage (31, 32) par zéro du courant dans cette phase (18, 19, 20).

6. Procédé suivant l'une des revendications 1 à 5, dans lequel la distance (25) minimum dans le temps du créneau (21, 22, 23, 24) temporel au prochain passage (31, 32) par zéro du courant correspond à au moins un quart de la durée d'une période (30) de la fréquence du secteur.

7. Interrupteur (1) de générateur de moyenne ou haute tension,
- comprenant au moins deux sections (4, 5, 6) de coupure parallèles associées à une phase (18, 19, 20),
- comprenant des moyens (8, 11, 12, 13) de détection de passages (31, 32) par zéro du courant dans cette phase (18, 19, 20) ; et
- comprenant des moyens (3, 8) de commande d'au moins un mécanisme (3) de coupure en liaison d'action avec les sections (4, 5, 6) de coupure, de manière à ouvrir toutes les sections (4, 5, 6) de coupure parallèles associées à cette phase (18, 19, 20) dans un créneau (21, 22, 23, 24) temporel, qui est en relation avec les passages (31, 32) par zéro du courant dans cette phase (8, 19, 20),
**caractérisé en ce qu'**
une distance (26) dans le temps, entre l'ouverture d'une première section (4, 5, 6) de coupure parallèle s'ouvrant en premier et l'ouverture d'une section (4, 5, 6) de coupure parallèle s'ouvrant en dernier, correspond, au plus, à un cinquième d'une durée d'une période (30) d'une fréquence du secteur.

8. Interrupteur (1) de générateur suivant la revendication 7, qui est constitué pour un secteur polyphasé.
